# EUROPEAN PATENT APPLICATION

(11) **EP 4 642 156 A1**
(43) Date of publication of application: **29.10.2025**
(21) Application number: 23905363.0
(22) Date of filing: 26.09.2023
(51) Int. Cl.: H05B 6/06, H05B 6/12

(54) **LOAD DETECTION CIRCUIT, LOAD DETECTION METHOD AND HOUSEHOLD APPLIANCE**

(30) Priority: 22.12.2022 CN 202211658697
(71) Applicant: Foshan Shunde Midea Electrical Heating Appliances Manufacturing Co., Ltd., Foshan, Guangdong 528311 (CN)
(72) Inventor: ZHANG, Youzhi, Foshan, Guangdong 528311 (CN); ZENG, Feng, Foshan, Guangdong 528311 (CN); LI, Hang, Foshan, Guangdong 528311 (CN); WANG, Zhifeng, Foshan, Guangdong 528311 (CN); ZENG, Xianguang, Foshan, Guangdong 528311 (CN); YU, Kun, Foshan, Guangdong 528311 (CN); CHEN, Wei, Foshan, Guangdong 528311 (CN)
(74) Representative: Ran, Handong
(86) International application number: PCT/CN2023/121565
(87) International publication number: WO 2024/131190

(57) **Abstract**

Disclosed in the present application are a load detection circuit, a load detection method and a household appliance. The circuit comprises a rectification unit, a control unit, a heating unit and a reversing unit, wherein the rectification unit is used for rectifying a high-level current or a low-level current; the heating unit is electrically connected to the rectification unit, the heating unit comprises two separate resonant heating loops, and the two separate resonant heating loops are respectively connected to a control port of the control unit and receive a control signal from the control unit; the reversing unit is electrically connected to a receiving port of the heating unit and a receiving port of the control unit, respectively, and transfers a reversing signal to the control unit; and the control unit is also used for acquiring a reversing duration according to the reversing signal, and determining whether there is a load. The connection of a heating unit is controlled by means of a control unit, such that the heating unit can be prevented from being in a discharge state for a long time and from being interfered with by an external magnetic field, thereby improving the accuracy of a load detection circuit.

## Description

### CROSS REFERENCE OF RELATED APPLICATIONS

This application claims priority to Chinese Application No. 202211658697.2 filed on December 22, 2022, the entire content of which is incorporated herein by reference for all purposes.

### FIELD

The present application relates to the technical field of circuit control, and more specifically, relates to a load detection circuit, a load detection method, and a household appliance.

### BACKGROUND

A household induction heating device will conduct a detection of whether a heated appliance (such as a cookware) is present or not before heating. The number of current reversals is detected through charging a coil disc and a capacitor, and then whether the heated appliance is present or absent is determined based on the number of current reversals, that is, whether the heated appliance has been placed on the induction heating device is determined.

### SUMMARY

In view of the above problem, the present application proposes a load detection circuit, a load detection method, and a household appliance to solve the above problem.

According to a first aspect, an embodiment of the present application proposes a load detection circuit, comprising: a rectification unit, and the rectification unit is configured to rectify a high-level current or a low-level current; a control unit, comprising an input port, a control port, a receiving port and an output port, and, the input port is configured to receive a load detection instruction, and the output port is configured to feed back a load detection result; a heating unit electrically connected to the rectification unit, and, the heating unit comprises two independent resonant heating circuits, and each of the two independent resonant heating circuits is connected to the control port of the control unit and configured to receive a control signal from the control unit; when the rectification unit inputs a rectified high-level current to the heating unit, the control signal controls one resonant heating circuit to be connected, and when the rectification unit inputs a rectified low-level current to the heating unit, the control signal controls the other resonant heating circuit to be connected; a reversing unit, which is electrically connected to the heating unit and the receiving port of the control unit respectively, and transmits a reversing signal to the control unit; and, the control unit is further configured to obtain a reversing duration based on the reversing signal, and determine whether a load exists.

According to a second aspect, an embodiment of the present application further provides a load detection method. The method is applied to the load detection circuit described in the first aspect above, and comprises: acquiring a load detection instruction; acquiring a reversing signal of a reversing unit based on the load detection instruction; acquiring a reversing duration corresponding to the reversing signal based on the reversing signal; and determining that a load exists if the reversing duration is less than a preset reversing duration.

According to a third aspect, the embodiment of the present application further proposes a load detection device, which is applied to the load detection circuit described in the first aspect above, and comprises: a load detection instruction acquisition module, a reversing signal acquisition module, a reversing duration acquisition module, and a load determining module. And, the load detection instruction acquisition module is configured to acquire a load detection instruction; the reversing signal acquisition module is configured to acquire the reversing signal of a reversing unit based on the load detection instruction; the reversing duration acquisition module is configured to acquire a reversing duration corresponding to the reversing signal based on the reversing signal; the load determining module is configured to determine that a load exists if the reversing duration is less than a preset reversing duration.

According to a fourth aspect, an embodiment of the present application further proposes a household appliance, which comprises an appliance body and the load detection circuit described in the first aspect above, and the load detection circuit is arranged in the appliance body.

According to a fifth aspect, an embodiment of the present application proposes a computer-readable storage medium. The computer-readable storage medium stores a program code, and the program code is invoked by a processor to execute the method described in the second aspect above.

### BRIEF DESCRIPTION OF THE DRAWINGS

In order to more clearly illustrate the technical solutions in the embodiments of the present application, the following briefly introduces the accompanying drawings that need to be used in the description of the embodiments. Obviously, the accompanying drawings in the following description are only some embodiments of the present application, rather than all of them. Based on the embodiments of the present application, all other embodiments and accompanying drawings obtained by those of ordinary skill in the art without creative efforts shall fall within the protection scope of the present application.
FIG. 1 shows a schematic view of the structure of a load detection circuit provided by an embodiment of the present application;
FIG. 2 shows a schematic view of the structure of a load detection circuit provided by an exemplary embodiment of the present application;
FIG. 3 shows a schematic view of the structure of a load detection circuit provided by another embodiment of the present application;
FIG. 4 shows a schematic view of the structure of a load detection circuit provided by another exemplary embodiment of the present application;
FIG. 5 shows a schematic flowchart of a load detection method provided by an embodiment of the present application;
FIG. 6 shows a block diagram of the structure of a load detection device provided by an embodiment of the present application;
FIG. 7 shows a block diagram of the structure of a household appliance provided by an embodiment of the present application; and
FIG. 8 shows a block diagram of the structure of a computer-readable storage medium provided by an embodiment of the present application.

### DETAILED DESCRIPTION OF THE APPLICATION

In order to enable those skilled in the art to better understand the solutions of the present application, the following will clearly and completely describe the technical solutions in the embodiments of the present application with reference to the accompanying drawings in the embodiments of the present application.

Existing induction heating cooking appliances will conduct a detection of whether a cookware is present or not before heating. Some of them turn on an IGBT (Insulated Gate Bipolar Transistor) switch for a fixed period of time to charge the coil disc and the capacitor, and then turn off the IGBT. They determine whether the cookware is present or absent by detecting the number of current reversals. At this moment, the coil disc is in a natural discharge state and is very susceptible to the interference of an external magnetic field. Moreover, the coil disc will absorb the energy of the interference, which may lead to a failure in detecting the cookware or a misjudgment of the absence of a cookware as the presence of a cookware. In addition, when multiple furnace heads are operating simultaneously, this method requires stopping the other furnace heads that are currently working to avoid interference from the heating of these furnace heads, which affects user experience. Furthermore, in terms of the hardware circuit, this method often requires a current transformer to collect a current detection circuit, which increases the cost.

Inventors propose the load detection circuit, the load detection method, and the household appliance provided in the present application, and, the load detection circuit comprises: a rectification unit, and the rectification unit is configured to rectify a high-level current or a low-level current; a control unit, comprising an input port, a control port, a receiving port and an output port, and, the input port is configured to receive a load detection instruction, and the output port is configured to feed back a load detection result; a heating unit electrically connected to the rectification unit, and, the heating unit comprises two independent resonant heating circuits, and the two independent resonant heating circuits are respectively connected to the control port of the control unit and receive a control signal from the control unit; when the rectification unit inputs a rectified high-level current to the heating unit, the control signal controls one resonant heating circuit to be connected, and when the rectification unit inputs a rectified low-level current to the heating unit, the control signal controls the other resonant heating circuit to be connected; a reversing unit, which is electrically connected to the heating unit and the receiving port of the control unit respectively, and transmits a reversing signal to the control unit; and, the control unit is further configured to obtain a reversing duration based on the reversing signal, and determine whether a load exists. By using the control unit to control the connection of the heating unit, it can prevent the heating unit from being in a discharge state for a long time and being interfered with by an external magnetic field, and the control unit further receives the reversing signal from the reversing unit, and the reversing unit analyzes the reversing signal. If there is a load placed on the heating unit, the corresponding reversing duration in the reversing signal is less than the preset reversing duration. Therefore, this can not only improve the anti-interference ability of the load detection circuit but also enhance the accuracy of the load detection circuit.

In the following, the load detection circuit provided by the embodiments of the present application will be described in detail through specific examples.

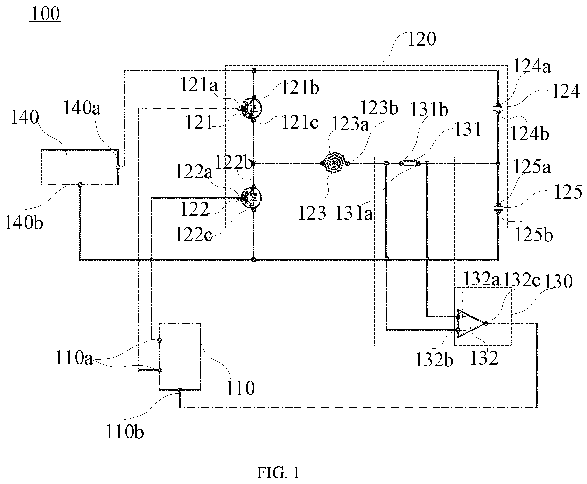

Referring to FIG. 1, an embodiment of the present application provides a load detection circuit 100, and the load detection unit 100 comprises a control unit 110, a heating unit 120, a reversing unit 130, and a rectification unit 140. And, the control unit 110 is electrically connected to the heating unit 120, the rectification unit 140 is electrically connected to the heating unit, and the reversing unit 130 is electrically connected to the control unit 110 and the heating unit 120 respectively.

In the embodiments of the present application, the control unit 110 is configured to control the connection of the heating unit 120 and to analyze and process the signals transmitted by the reversing unit 130. The control unit 110 can comprise an input port (not shown in the drawings), a control port 110a, a receiving port 110b, and an output port (not shown in the drawings). The input port is configured to receive a load detection instruction, and the output port is configured to feed back the load detection result.

In an embodiment, the control unit 110 can comprise an integrated circuit chip. Taking a microcontroller as an example of the integrated circuit chip, it uses a very-large-scale integration technology to integrate functions such as a central processing unit (CPU) with a data processing ability, a random access memory, a read-only memory, various interrupt systems, a timer/counter, and a transmitter onto a single silicon chip to form a small and complete microcomputer system. The input port of the control unit 110 receives the user's instruction signal and is electrically connected to the control port 110 a through the transmitter to transmit the control signal, thereby enabling the circuit to operate according to the user's instruction signal.

In an embodiment, the integrated circuit chip can be an STM32 microcontroller, a 51 microcontroller, or other integrated circuit chips. The specific choice can be made according to actual needs, and the present application does not impose any restrictions on this.

In another implementation, the control unit 110 can further be a Programmable Logic Controller (PLC for short). A PLC is a digital electronic device with a microprocessor and serves as a digital logic controller for automated control, and can load control instructions into the memory for storage and execution at any time. A programmable controller is modularly composed of an internal CPU, instruction and data memory, an input/output unit, a power supply module, a digital analog unit, etc. Users transmit an instruction signal through the PLC, and the instruction signal is transmitted from the transmission port of the PLC to the control port of the control unit 110.

In the embodiments of the present application, as shown in FIG. 1, the heating unit 120 comprises at least two resonant heating circuits. The at least two independent resonant heating circuits are respectively connected to the control port 110a of the control unit 110.

The heating unit 120 can comprise a coil disc with a relatively large resistance value. Through the action of electric current, the temperature of the coil disc rises, to achieve the heating of the object placed on the coil disc. The heating unit 120 can further comprise a resonant heating unit composed of a capacitor and a coil. In the solution of the present application, the resonant heating unit composed of a capacitor and a coil is preferred.

Specifically, referring to FIG. 1, the heating unit 120 can comprise a first IGBT 121, a second IGBT 122, a coil disc 123, a first capacitor 124, and a second capacitor 125.

An IGBT is a composite fully-controlled voltage-driven power semiconductor device composed of a bipolar transistor and an insulated gate field effect transistor.

The first IGBT 121 comprises a first port 121a, a second port 121b, and a third port 121c. The first port 121a of the first IGBT 121 is connected to the control port 110a of the control unit 110, and the second port 121b of the first IGBT 121 is connected to the rectification unit 140.

The second IGBT 122 comprises a first port 122a, a second port 122b, and a third port 122c. The first port 122a of the second IGBT 122 is connected to the control port 110a of the control unit 110. The third port 122c of the second IGBT 122 is connected to the rectification unit 140.

The coil disc 123 comprises a first port 123a and a second port 123b. The third port 121c of the first IGBT 121 is connected to the first port 123a of the coil disc 123. The first port 123a of the coil disc 123 is connected to the second port 122b of the second IGBT 122.

The first capacitor 124 comprises a first port 124a and a second port 124b. The first port 124a of the first capacitor 124 is connected to the rectification unit 140, and the second port 124b of the first capacitor 124 is connected to the second port 123b of the coil disc 123.

The second capacitor 125 comprises a first port 125a and a second port 125b. The second port 123b of the coil disc 123 is connected to the first port 125a of the second capacitor 125, and the second port 125b of the second capacitor 125 is connected to the rectification unit 140.

A first resonant heating circuit is formed by connecting the first IGBT 121, the coil disc 123, and the first capacitor 124 in series. A second resonant heating circuit is formed by the second IGBT 122, the coil disc 123, and the second capacitor 125. The control unit 110 controls the conduction or cutoff of the IGBTs in each resonant heating circuit through the control signal to independently control multiple resonant heating circuits for heating.

In the embodiments of the present application, the reversing unit 130 is configured to receive the voltage reversing signal from the heating unit 120 and transmit it to the control unit 110.

The reversing unit 130 is respectively connected to the heating unit 120 and the receiving port 110b of the control unit 110. The reversing unit 130 transmits the reversing signal to the control unit 110, and the control unit 110 determines whether the load exists based on the reversing signal.

The reversing signal refers to a voltage reversing signal generated by the first capacitor 124 and the second capacitor 125 in the heating unit 120 under the action of alternating current.

In some implementations, the reversing unit 130 can comprise a first resistor 131 and a reversing detection unit 132.

The first resistor 131 can comprise a first port 131a and a second port 131b. The reversing detection unit 132 can comprise a first port 132a, a second port 132b, and a third port 132c. The first port 131a of the first resistor 131 is connected to the second port 124b of the first capacitor 124 and the first port 125a of the second capacitor 125, and the second port 131b of the first resistor 131 is connected to the second port 123b of the coil disc 123. The first port 132a of the reversing detection unit 132 is connected to the first port 131a of the first resistor 131, the second port 132b of the reversing detection unit 132 is connected to the second port 131b of the first resistor 131, the third port 132c of the reversing detection unit 132 is connected to the receiving port 110b of the control unit 110, and the reversing detection unit 132 is configured to detect the voltage direction across the first resistor 131.

The rectification unit 140 can be a full bridge rectifier or an inverter. The rectification unit 140 can rectify the alternating current output from an alternating current power supply and supply the rectified alternating current to the heating unit 120.

The rectification unit 140 can comprise a first port 140a and a second port 140b. In this embodiment, the first port 140a of the rectification unit 140 is connected to the second port 121b of the first IGBT 121 and the first port 124a of the first capacitor 124 to provide current for the first independent resonant heating circuit and the second independent resonant heating circuit. The second port 140b of the rectification unit 140 is connected to the second port 125b of the second capacitor 125 and the third port 122c of the second IGBT 122 to form a complete current circuit. When the rectification unit 140 inputs the rectified high-level current to the first independent resonant heating circuit, the control signal controls the first independent resonant heating circuit to be connected. When the rectification unit inputs the rectified low-level current to the second independent resonant heating circuit, the control signal controls the second independent resonant heating circuit to be connected.

The reversing detection unit 132 can be a voltage comparator or a device provided with software for detecting the ADC value of the voltage at two ends of the first resistor 131.

In actual use, when the control unit 110 controls the IGBTs in the first independent resonant heating circuit and the second independent resonant heating circuit to be alternately connected, an alternating current will be generated in the coil disc 123 connected to the IGBTs. As the current flows alternately, the voltage direction of the first resistor 131 connected in series with the coil disc 123 further changes alternately.

After the control unit 110 acquires the voltage reversing signal of the first resistor 131, it processes the voltage reversing signal to obtain a reversing duration corresponding to the voltage reversing signal. The control unit 110 compares the reversing duration with the preset reversing duration to determine whether there is a load on the coil disc 123, and outputs the determining result through the output port.

The load detection circuit provided in this embodiment detects the reversing signal in the circuit by alternately turning on the first IGBT 121 and the second IGBT 122 in the heating unit 120, and then detects whether there is a load on the coil disc 123 based on the reversing duration. It does not require the coil disc 123 to be in a natural discharge state for a long time, and avoids the interference of the coil disc 123 from the external magnetic field, and improves the accuracy and anti-interference ability of the load detection circuit.

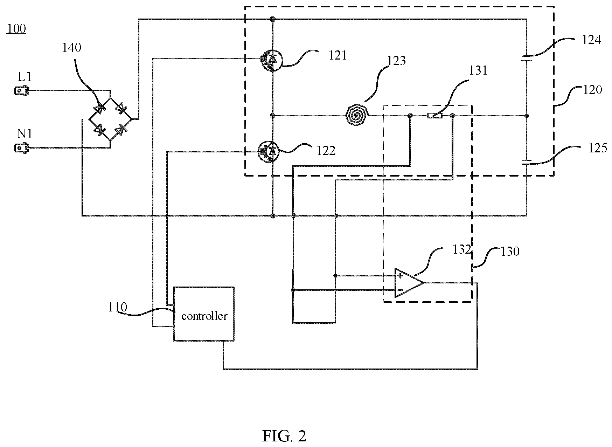

Referring to FIG. 2, FIG. 2 shows a schematic view of a load detection circuit provided in an exemplary embodiment of the present application.

The rectification unit 140 further comprises two input terminals, namely L1 and N1. Within one alternating current cycle, when a high-level current is input into the input terminal L1, the rectification unit 140 rectifies the high-level current, and the rectified current flows to the first IGBT 121 of the heating unit 120. The control unit 110 controls the first IGBT 121 to be connected. The first IGBT 121 is connected in series with the coil disc 123, the first resistor 131, and the second capacitor 125. The high-level current flows through the first IGBT 121, the coil disc 123, the first resistor 131, and the second capacitor 125 in sequence and then returns to the rectification unit 140.

When a low-level current is input into the input terminal N1, the rectified current flows through the first capacitor 124, the first resistor 131, and the coil disc 123 in sequence. When the current flows through the second IGBT 122, the control unit 110 controls the second IGBT 122 to be connected. The second IGBT 122 is connected to the rectification unit 140 to form a closed circuit.

The reversing detection unit 132 is connected to the two ends of the first resistor 131 and is configured to detect whether the first resistor 131 generates a reversing voltage under different level inputs. The detected reversing signal is transmitted to the control unit 110, and the control unit 110 detects whether there is a load on the coil disc 123 based on the reversing duration corresponding to the acquired reversing signal. If there is a load on the coil disc 123, under the same IGBT turn-on time, the resistance coupled between the load and the coil disc 123 will increase, so the voltage reversing duration will become shorter.

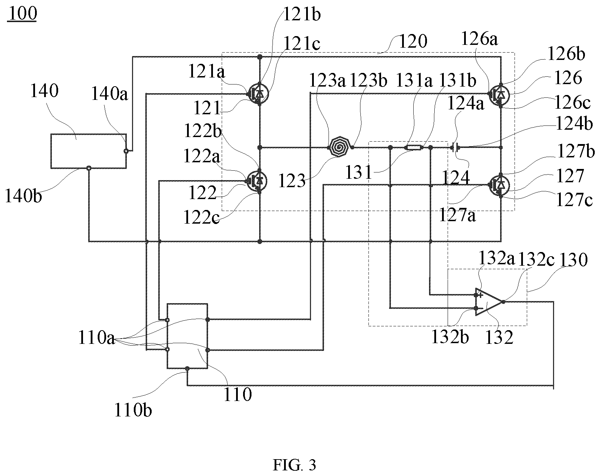

Referring to FIG. 3, FIG. 3 shows a load detection circuit provided in some other embodiments of the present application. The circuit comprises a rectification unit 140, a control unit 110, a heating unit 120, and a reversing unit 130. And, the rectification unit 140 is electrically connected to the control unit 110, the control unit 110 is electrically connected to the heating unit 120, and the reversing unit 130 is connected to the control unit 110 and the heating unit 120 respectively.

In the embodiments of the present application, the heating unit can comprise a first IGBT 121, a second IGBT 122, a coil disc 123, a first capacitor 124, a third IGBT 126, and a fourth IGBT 127.

The first IGBT 121 comprises a first port 121a, a second port 121b, and a third port 121c. The first port 121a of the first IGBT 121 is connected to the control port 110a of the control unit 110, and the second port 121b of the first IGBT 121 is connected to the rectification unit 140.

The second IGBT 122 comprises a first port 122a, a second port 122b, and a third port 122c. The first port 122a of the second IGBT 122 is connected to the control port 110a of the control unit 110, and the second port 122b of the second IGBT 122 is connected to the rectification unit 140.

The coil disc 123 comprises a first port 123a and a second port 123b. The third port 121c of the first IGBT 121 is connected to the first port 123a of the coil disc 123.

The first capacitor 124 comprises a first port 124a and a second port 124b. The second port 123b of the coil disc 123 is connected to the first port 124a of the first capacitor 124.

The third IGBT 126 comprises a first port 126a, a second port 126b, and a third port 126c. The first port 126a of the third IGBT 126 is connected to the control port 110a of the control unit 110, the second port 126b of the third IGBT 126 is connected to the rectification unit 140, and the third port 126c of the third IGBT 126 is connected to the second port 124b of the first capacitor 124.

The fourth IGBT 127 comprises a first port 127a, a second port 127b, and a third port 127c. The second port 124b of the first capacitor 124 is connected to the second port 127b of the fourth IGBT 127. The third port 127c of the fourth IGBT 127 is connected to the rectification unit 140. The first port 127a of the fourth IGBT 127 is connected to the control port 110a of the control unit 110.

The rectification unit 140 can comprise a first port 140a and a second port 140b. In this embodiment, the first port 140a of the rectification unit 140 is connected to the second port 121b of the first IGBT 121 and the second port 126b of the third IGBT 126 to provide current for the first independent resonant heating circuit and the second independent resonant heating circuit. The second port 140b of the rectification unit 140 is connected to the third port 122c of the second IGBT 122 and the third port 127c of the fourth IGBT 127 to form a complete current circuit. When the rectification unit 140 inputs the rectified high-level current to the first independent resonant heating circuit, the control signal controls the first independent resonant heating circuit to be connected. When the rectification unit inputs the rectified low-level current to the second independent resonant heating circuit, the control signal controls the second independent resonant heating circuit to be connected.

In the embodiments of the present application, the reversing unit 130 can comprise the first resistor 131 and the reversing detection unit 132.

The first resistor 131 comprises the first port 131a and the second port 131b. The first port 131a of the first resistor 131 is connected to the second port 123b of the coil disc 123, and the second port 131b of the first resistor 131 is connected to the first port 124a of the first capacitor 124.

The reversing detection unit 132 comprises the first port 132a, the second port 132b, and the third port 132c. The first port 132a of the reversing detection unit 132 is connected to the first port 131a of the first resistor 131, the second port 132b of the reversing detection unit 132 is connected to the second port 131b of the first resistor 131, and the third port 132c of the reversing detection unit 132 is connected to the receiving port 110b of the control unit 110. The reversing detection unit 132 is configured to detect the voltage direction across the two ends of the first resistor 131.

The embodiments of the present application at least comprise four IGBTs. Every two IGBTs are respectively connected in series with the coil disc and the capacitor to form a independent resonant heating circuit.

Specifically, in this embodiment, the control unit controls the conduction or cutoff of the IGBTs in each resonant heating circuit to independently control multiple resonant heating circuit for heating. The multiple resonant heating circuit can heat alternately or simultaneously. When the multiple resonant heating circuits heat alternately, the service life of the heating devices in the resonant heating circuits can be extended. When the multiple resonant heating circuits heat simultaneously, a larger area can be heated within the same period of time, or it takes less time to heat to a predetermined temperature. When at least four IGBTs are installed in the resonant heating circuit, the working pressure on each IGBT can be reduced, to prolong the service life of the IGBTs.

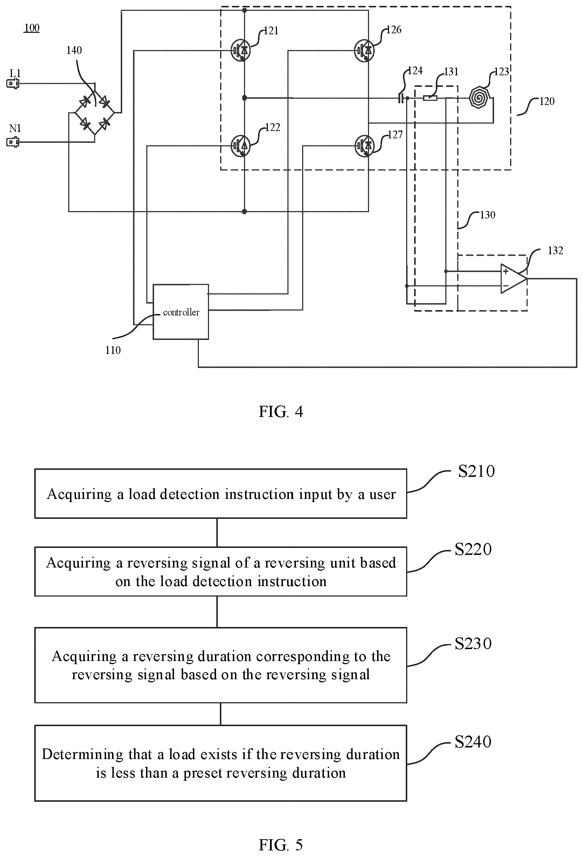

Referring to FIG. 4, FIG. 4 shows a schematic view of a load detection circuit provided by an exemplary embodiment of the present application.

In one alternating current cycle, when a high-level current is input to the input terminal L1, the rectification unit 140 rectifies the high-level current, and the rectified current flows to the first IGBT 121 and the fourth IGBT 127 of the heating unit 120. The control unit 110 controls the first IGBT 121 and the fourth IGBT 127 to be connected. The first IGBT 121 is connected in series with the first capacitor 124, the first resistor 131, the coil disc 123, and the fourth IGBT 127 in sequence. The high-level current flows through the first IGBT 121, the first capacitor 124, the first resistor 131, the coil disc 123, and the fourth IGBT 127 in sequence and then returns to the rectification unit.

When a low-level current is input to the input terminal N1, the rectification unit 140 rectifies the low-level current, and the rectified current flows to the second IGBT 122 and the third IGBT 126 of the heating unit 120. The control unit controls the second IGBT 122 and the third IGBT 126 to be connected. The third IGBT 126 is connected in series with the first capacitor 124, the first resistor 131, the coil disc 123, and the second IGBT 122 in sequence. The low-level current flows through the third IGBT 126, the first capacitor 124, the first resistor 131, the coil disc 123, and the second IGBT 122 in sequence and then returns to the rectification unit 140.

The reversing detection unit 132 is connected to the two ends of the first resistor 131 and is configured to detect whether the first resistor 131 generates a reversing voltage under different level inputs. The detected reversing signal is transmitted to the control unit 110, and the control unit 110 detects whether there is a load on the coil disc 123 based on the acquired reversing signal and the connection duration of the multiple IGBTs. If there is a load on the coil disc 123, under the same IGBT turn-on time, the resistance coupled between the load and the coil disc will increase, so the reversing duration of capacitor voltage and the IGBT turn-on time will become shorter.

Referring to FIG. 5, FIG. 5 shows a schematic flowchart of a load detection method provided by an embodiment of the present application, which is applied to the aforementioned load detection circuit. The load detection method comprises step S210 to step S240.

Step S210: acquiring a load detection instruction.

The load detection instruction can be a test instruction obtained through a computer, or can be set by developers during the development process, and the purpose is to first determine whether there is a load on the coil disc at the beginning of the connection of the load detection circuit.

Step 220: acquiring a reversing signal of a reversing unit based on the load detection instruction.

The control unit receives the load detection instruction, and connects the heating unit based on the detection signal. Due to the alternating connection of the IGBTs, the capacitor in the heating unit will generate a reversing voltage. The reversing unit can be connected to the heating unit to obtain the voltage reversing signal of the heating unit.

Step 230: acquiring a reversing duration corresponding to the reversing signal based on the reversing signal.

Based on the reversing signal detected by the reversing unit, the reversing duration of the first resistor within one alternating current cycle is obtained. The reversing duration refers to the reversing duration obtained by the control unit through analysis and processing of the reversing signal. The reversing duration can be the reversing duration from the moment when the heating unit starts receiving a high-level current to the moment when the heating unit receives a low-level current, and can further be the reversing duration from the moment when the heating unit switches from a high-level current to a low-level current to the moment when the heating unit switches back to a high-level current. There is no specific limitation on the reversing duration here.

Step 240: determining that a load exists if the reversing duration is less than a preset reversing duration.

The preset connection duration refers to the connection duration of an IGBT unit measured without a load, and the preset reversing duration refers to the voltage reversing duration across the first resistor measured without a load.

When a load is placed on the coil disc, the load is equipped with a heatable coil. The coupling between the heatable coil and the coil disc in the heating unit will increase the resistance of the coil disc. At this time, under the action of the same current, the time for the current to flow through the first resistor and the IGBT unit becomes shorter. In some implementations, if the reversing duration is greater than and/or equal to the preset reversing duration, it is determined that the load does not exist.

When no load is placed on the coil disc, the resistance of the first resistor, wires, or capacitors in the circuit will be increased due to reasons such as the long-term use, thus making the connection duration greater than and/or equal to the preset connection duration, and the reversing duration greater than and/or equal to the preset reversing duration. At this time, it is determined that the load does not exist.

By comparing the reversing duration obtained from the reversing unit with the preset reversing duration, it is possible to more accurately determine whether there is a load in the load detection circuit, thus avoiding interference when the coil disc in the heating unit is discharging for a long time.

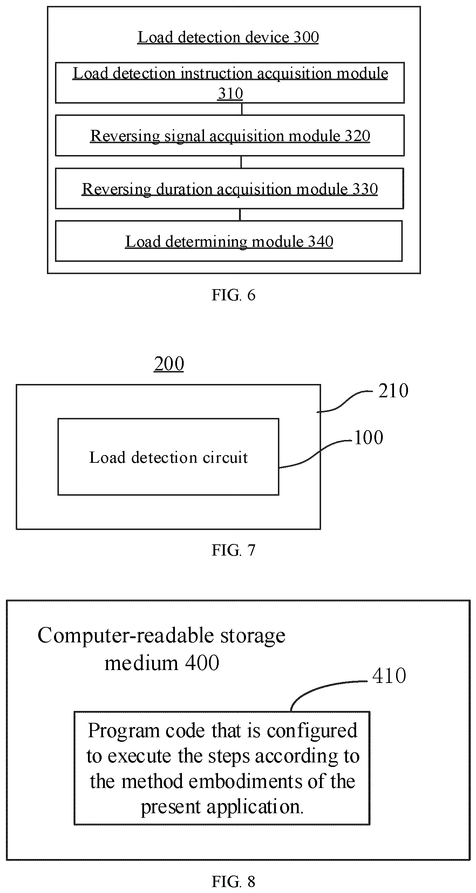

Referring to FIG. 6, FIG. 6 shows a block diagram of the modules of the load detection device provided in this embodiment. The following will elaborate on the block diagram shown in FIG. 6. The load detection device 300 is applied to the aforementioned load detection circuit. This device comprises: a load detection instruction acquisition module 310, a reversing signal acquisition module 320, a reversing duration acquisition module 330, and a load determining module 340. And:
The load detection instruction acquisition module 310 is configured to acquire the load detection instruction.

The reversing signal acquisition module 320 is configured to acquire the reversing signal of the reversing unit based on the load detection instruction.

The reversing duration acquisition module 330 is configured to acquire the reversing duration corresponding to the reversing signal based on the reversing signal.

The load determining module 340 is configured to determine that the load exists if the reversing duration is less than the preset reversing duration.

In summary, the embodiments of the present application provide a load detection circuit, a load detection method, and a household appliance, and, the load detection circuit comprises a control unit, a heating unit, and a reversing unit. The control unit controls the connection of the heating unit, which can prevent the heating unit from being in a discharging state for a long time and being interfered with by an external magnetic field. The control unit further receives the reversing signal from the reversing unit, and the reversing unit analyzes the reversing signal. If there is a load placed on the heating unit, the reversing duration corresponding to the reversing signal is less than the preset reversing duration. Therefore, this not only improves the anti-interference ability of the load detection circuit but also enhances the accuracy of the load detection circuit.

Referring to FIG. 7, the embodiment of the present application further provides a household appliance 200. The household appliance 200 comprises an appliance body 210 and the aforementioned load detection circuit 100, and, the load detection circuit 100 is provided in the appliance body 210.

The household appliance can be one that requires load detection during operation. In an embodiment, the household appliance can comprise an induction cooker, a food processor, and a heating dining table.

Referring to FIG. 8, it shows a block diagram of the structure of a computer-readable storage medium provided by an embodiment of the present application. The computer-readable medium 400 stores a program code, and the program code can be invoked by a processor to execute the method described in the above method embodiments.

The computer-readable storage medium 400 can be electronic memory such as flash memory, EEPROM (Electrically Erasable Programmable Read-Only Memory), EPROM, a hard disk, or ROM. In an embodiment, the computer-readable storage medium 400 comprises a non-transitory computer-readable storage medium. The computer-readable storage medium 400 has storage space for a program code 410 that executes any of the method steps described above. These program codes can be read from or written into one or more computer program products. The program code 410 can be compressed in an appropriate form, for example.

Finally, it should be noted that the above embodiments are only configured to illustrate the technical solutions of the present application, and are not intended to limit them. Although the present application has been described in detail with reference to the foregoing embodiments, those of ordinary skilled in the art should understand that they can still modify the technical solutions described in the foregoing embodiments or make equivalent substitutions for some of the technical features. However, these modifications or substitutions do not cause the essence of the corresponding technical solutions to deviate from the spirit and scope of the technical solutions of the various embodiments of the present application.

## Claims

1. A load detection circuit, comprising:
a rectification unit, configured to rectify a high-level current or a low-level current;
a control unit, comprising an input port, a control port, a receiving port and an output port, wherein, the input port is configured to receive a load detection instruction, and the output port is configured to feed back a load detection result;
a heating unit electrically connected to the rectification unit, comprising two independent resonant heating circuits, wherein each of the two independent resonant heating circuits is connected to the control port of the control unit and configured to receive a control signal from the control unit, when the rectification unit inputs a rectified high-level current to the heating unit, the control signal controls one of the resonant heating circuits to be connected, and when the rectification unit inputs a rectified low-level current to the heating unit, the control signal controls the other one of the resonant heating circuits to be connected; and
a reversing unit, electrically connected to the heating unit and the receiving port of the control unit, and configure to transmit a reversing signal to the control unit,
wherein the control unit is further configured to obtain a reversing duration based on the reversing signal, and determine whether a load exists.

2. The circuit according to claim 1, wherein, the heating unit comprises:
a first Insulated Gate Bipolar Transistor, IGBT, comprising a first port, a second port, and a third port;
a second IGBT, comprising a first port, a second port, and a third port;
a coil disc, comprising a first port and a second port;
a first capacitor, comprising a first port and a second port; and
a second capacitor, comprising a first port and a second port, wherein:
the first port of the first IGBT is connected to the control port of the control unit, the second port of the first IGBT is electrically connected to the rectification unit, the third port of the first IGBT is connected to the first port of the coil disc, the second port of the coil disc is connected to the first port of the second capacitor, and the second port of the second capacitor is electrically connected to the rectification unit, forming a first resonant heating circuit;
when the rectification unit inputs the rectified high-level current to the heating unit, the control signal controls the first resonant heating circuit to be connected;
the first port of the second IGBT is connected to the control port of the control unit, the first port of the first capacitor is electrically connected to the rectification unit, the second port of the first capacitor is connected to the second port of the coil disc, the first port of the coil disc is connected to the second port of the second IGBT, and the third port of the second IGBT is electrically connected to the rectification unit, forming a second independent resonant heating circuit; and
when the rectification unit inputs the rectified low-level current to the heating unit, the control signal controls the second resonant heating circuit to be connected.

3. The circuit according to claim 2, wherein:
the rectification unit comprises a first port and a second port; and
the first port of the rectification unit is connected to the second port of the first IGBT and the first port of the first capacitor, the second port of the rectification unit is connected to the second port of the second capacitor and the third port of the second IGBT, forming a complete current circuit.

4. The circuit according to claim 2, wherein, the reversing unit comprises:
a first resistor, comprising a first port and a second port; and
a reversing detection unit, comprising a first port, a second port, and a third port, wherein:
the first port of the first resistor is connected to the second port of the first capacitor and the first port of the second capacitor, and the second port of the first resistor is connected to the second port of the coil disc; and
the first port of the reversing detection unit is connected to the first port of the first resistor, the second port of the reversing detection unit is connected to the second port of the first resistor, the third port of the reversing detection unit is connected to the receiving port of the control unit, and the reversing detection unit is configured to detect the voltage direction across the first resistor.

5. The circuit according to claim 4, wherein, the reversing detection unit comprises: a voltage comparator or a device provided with software for detecting the nuclear magnetic resonance ADC value of the voltage across the first resistor.

6. The circuit according to claim 2, wherein, the heating unit further comprises:
a third IGBT, comprising a first port, a second port, and a third port; and
a fourth IGBT, comprising a first port, a second port, and a third port, wherein:
the first port of the first IGBT is connected to the control port of the control unit, the second port of the first IGBT is electrically connected to the rectification unit, the third port of the first IGBT is connected to the first port of the coil disc, the second port of the coil disc is connected to the first port of the first capacitor, the second port of the first capacitor is connected to the second port of the fourth IGBT, the third port of the fourth IGBT is electrically connected to the rectification unit, and the first port of the fourth IGBT is connected to the control port of the control unit, forming the first resonant heating circuit;
when the rectification unit inputs the rectified high-level current to the heating unit, the control signal controls the first resonant heating circuit to be connected;
the first port of the second IGBT is connected to the control port of the control unit, the second port of the second IGBT is electrically connected to the rectification unit, the third port of the second IGBT is connected to the second port of the first capacitor, the first port of the first capacitor is connected to the second port of the coil disc, the first port of the coil disc is connected to the second port of the third IGBT, the third port of the third IGBT is electrically connected to the rectification unit, and the first port of the third IGBT is connected to the control port of the control unit, forming the second independent resonant heating circuit; and
when the rectification unit inputs the rectified low-level current to the heating unit, the control signal controls the second resonant heating circuit to be connected.

7. The circuit according to claim 6, wherein, the rectification unit comprises:
a first port and a second port, wherein, the first port of the rectification unit is connected to the second port of the first IGBT and the second port of the second IGBT, and the second port of the rectification unit is connected to the third port of the fourth IGBT and the third port of the third IGBT, forming a complete current circuit.

8. The circuit according to claim 7, wherein, the rectification unit comprises:
an input terminal L1 and an input terminal N1, wherein, when a high-level current is input into the input terminal L1, the rectification unit rectifies the high-level current, and the rectified current flows to the first IGBT and the fourth IGBT, and when a low-level current is input into the input terminal N1, the rectification unit rectifies the low-level current, and the rectified current flows to the second IGBT and the third IGBT.

9. The circuit according to claim 2, wherein, the reversing unit comprises:
a first resistor, comprising a first port and a second port; and
a reversing detection unit, comprising a first port, a second port, and a third port, wherein:
the first port of the first resistor is connected to the second port of the coil disc;
the second port of the first resistor is connected to the first port of the first capacitor;
the first port of the reversing detection unit is connected to the first port of the first resistor;
the second port of the reversing detection unit is connected to the second port of the first resistor; and
the third port of the reversing detection unit is connected to the receiving port of the control unit, and the reversing detection unit is configured to detect the voltage direction across the first resistor.

10. The circuit according to claim 2, wherein, the reversing signal comprises a voltage reversing signal generated by the first capacitor and the second capacitor under the action of alternating current.

11. The circuit according to claim 2, wherein, the heating unit at least comprises four IGBTs, and every two of the four IGBTs are respectively connected in series with the coil disc and a capacitor included in the heating unit to form a resonant heating circuit.

12. A load detection method, wherein, the method is applied to the load detection circuit according to any one of claims 1 to 11, the method comprises:
acquiring a load detection instruction;
acquiring a reversing signal of the reversing unit based on the load detection instruction;
acquiring a reversing duration corresponding to the reversing signal based on the reversing signal; and
determining that a load exists if the reversing duration is less than a preset reversing duration.

13. The method according to claim 12, wherein, after said acquiring a reversing duration corresponding to the reversing signal based on the reversing signal, the method further comprises:
if the reversing duration is greater than and/or equal to the preset reversing duration, determining that the load does not exist.

14. The method according to claim 13, wherein, the method further comprises:
acquiring the connection duration of the heating unit based on the load detection instruction;
if the connection duration is greater than and/or equal to a preset connection duration and the reversing duration is greater than and/or equal to the preset reversing duration, determining that the load does not exist.

15. The method according to claim 12, wherein, the heating unit comprises a first IGBT and a second IGBT, and said acquiring a reversing signal of the reversing unit based on the load detection instruction comprises:
alternately turning on the first IGBT and the second IGBT in the heating unit based on the load detection instruction; and
acquiring the reversing signal of the reversing unit during the process of alternately turning on the first IGBT and the second IGBT in the heating unit.

16. The method according to claim 12, wherein, the reversing unit comprises a first resistor, and said acquiring a reversing duration corresponding to the reversing signal based on the reversing signal comprises:
acquiring the reversing duration of the first resistor within one alternating current cycle based on the reversing signal detected by the reversing unit.

17. The method according to claim 12, wherein, the reversing duration comprises a duration from the moment when the heating unit starts receiving a high-level current to the moment when the heating unit receives a low-level current, or a duration from the moment when the heating unit switches from a high-level current to a low-level current to the moment when the heating unit switches back to a high-level current.

18. A load detection device, applied to the load detection circuit according to any one of claims 1 to 11**,** wherein the device comprises:
a load detection instruction acquisition module, configured to acquire a load detection instruction;
a reversing signal acquisition module, configured to acquire the reversing signal of a reversing unit based on the load detection instruction;
a reversing duration acquisition module, configured to acquire a reversing duration corresponding to the reversing signal based on the reversing signal; and
a load determining module, configured to determine that a load exists if the reversing duration is less than a preset reversing duration.

19. A household appliance, comprising:
an appliance body, and the load detection circuit according to any one of claims 1 to 11, wherein the load detection circuit is arranged in the appliance body.

20. A computer-readable storage medium, wherein, the computer-readable storage medium stores a program code, and the program code is invoked by a processor to execute the method according to any one of claims 12 to 17.
